# EUROPEAN PATENT APPLICATION

(11) **EP 4 417 878 A1**
(43) Date of publication of application: **21.08.2024**
(21) Application number: 24151488.4
(22) Date of filing: 12.01.2024
(51) Int. Cl.: F24C 15/00, G01P 3/44

(54) **COOKING APPLIANCE AND COOLING UNIT DISPOSED THEREIN**

(30) Priority: 14.02.2023 KR 20230019522
(71) Applicant: LG Electronics Inc., Yeongdeungpo-gu Seoul 07336 (KR)
(72) Inventor: YU, Cheong Hwan, 08592 Seoul (KR)
(74) Representative: Vossius & Partner Patentanwälte Rechtsanwälte mbB

(57) **Abstract**

Disclosed are a cooling unit (100) and a cooking appliance including the same. An operation detecting module (150) that senses rotation of a cooling fan (120) includes a magnetic member (160) that generates a magnetic force, a detector (170) that senses the magnetic force, and an adjustment member ( 180) that opens and closes a passage where the magnetic force passes between the magnetic member (160) and the detector (170), and when the cooling fan (120)rotates, the adjustment member (180) operates such that a first operation of opening the passage and a second operation of closing the passage alternate repeatedly.

## Description

The present invention relates to a cooking appliance, and more specifically, to a cooking appliance that has a cooling unit that cools an electrical component chamber in which various electrical components are disposed.

### Description of Related Art

A cooking appliance is a type of home appliance for cooking food and is installed in a kitchen space to cook the food based on an intention of a user. Such cooking appliance may be classified in various ways depending on a heat source used, a shape, and a type of fuel.

When classifying the cooking appliance based on a type of cooking the food, the cooking appliance may be classified into an open cooking appliance and a closed cooking appliance depending on a shape of a space where the food is placed. The closed cooking appliance includes an oven, a microwave, and the like, while the open cooking appliance includes a cooktop, a hob, a griddle, and the like.

The closed cooking appliance is a cooking appliance that shields the space where the food is located and cooks the food by heating the shielded space. In the closed cooking appliance, a cooking chamber, which is the space where the food is placed and shielded when the food is to be cooked, is provided. Such cooking chamber becomes a space where the food is actually cooked.

In the closed cooking appliance, a door that selectively opens and closes the cooking chamber is pivotably disposed. The door may be pivotably installed on a main body by a door hinge disposed between the door and the main body with the cooking chamber formed therein, and selectively open and close the cooking chamber by pivoting around a portion coupled to the main body via the door hinge.

The heat source is disposed in an internal space of the cooking chamber opened and closed by the door to heat the cooking chamber. A gas burner, an electric heater, or the like may be used as such a heat source.

An electrical component chamber is formed on top of the cooking chamber. Electrical components necessary for operation of the closed cooking appliance may be disposed inside the electrical component chamber. Such electrical component chamber is formed as a space separate from the cooking chamber.

A cooling fan for cooling the electrical component chamber may be disposed inside the electrical component chamber. The cooling fan may be formed in a shape of a centrifugal fan, such as a sirocco fan, and may be disposed biased toward a rear portion of the electrical component chamber. Such cooling fan may cool the inside of the electrical component chamber by sucking outside air, and may cool the electrical component chamber by forcibly blowing hot air inside the electrical component chamber to the outside of the closed cooking appliance.

When a failure occurs in the cooling fan as described above, it is difficult to properly cool the electrical component chamber. When the electrical component chamber is not properly cooled, a temperature of the electrical components disposed inside the electrical component chamber increases excessively, which increases a possibility that a failure of the electrical components occurs.

The present invention is to provide a cooking appliance with an improved structure such that whether a failure has occurred in a cooling fan is quickly identified.

In addition, the present invention is to provide a cooking appliance with an improved structure such that a failure of electrical components resulted from overheating is prevented in advance.

In addition, the present invention is to provide a cooking appliance with an improved structure such that an increase in a size and a weight of an operation detecting module is suppressed.

In addition, the present invention is to provide a cooking appliance with an improved structure such that whether a failure of a cooling fan has occurred is identified regardless of a type of motor.

The invention is specified by the independent claims. Preferred embodiments are defined by the dependent claims. In a cooking appliance, which is one embodiment of the present invention to achieve the above purposes, an operation detecting module that senses rotation of a cooling fan includes a magnetic member that generates a magnetic force, a detector that senses the magnetic force, and an adjustment member that opens and closes a passage where the magnetic force passes between the magnetic member and the detector, and when the cooling fan rotates, the adjustment member operates such that a first operation of opening the passage and a second operation of closing the passage alternate repeatedly.

In another embodiment of the present invention, an operation of a heater is controlled using a result of monitoring the number of alternations of a magnetic force sensing state and a non-sensing state of a detector for each unit time.

A cooking appliance according to one aspect of the present invention may include a cavity having a cooking chamber defined therein, a heater that heats the cooking chamber, and an electrical component chamber defined outside the cavity, a cooling fan that rotates and generates a flow of cold air, and an operation detecting module that senses the rotation of the cooling fan.

The operation detecting module may include a magnetic member that generates a magnetic force, a detector that detects the magnetic force, and an adjustment member that opens and closes a passage where the magnetic force passes between the magnetic member and the detector.

When the cooling fan rotates, the adjustment member may operate such that a first operation of opening the passage and a second operation of closing the passage alternate repeatedly.

The adjustment member may rotate in association with the rotation of the cooling fan, and the operation of the adjustment member may change from the first operation to the second operation or from the second operation to the first operation by the rotation of the adjustment member.

The adjustment member may include a vane that rotates in association with the rotation of the cooling fan and circulates between a first location of blocking the passage and a second location of not blocking the passage.

When the vane is at the first location, the adjustment member may operate in the first operation, and when the vane is at the second location, the adjustment member may operate in the second operation.

The adjustment member may include a coupling shaft coupled to a shaft of a motor that rotates the cooling fan and rotating together with the shaft, and the vane disposed between the magnetic member and the detector, protruding in a centrifugal direction from the coupling shaft, and rotating together with the coupling shaft.

The adjustment member may include the vane that blocks the magnetic force in the passage, and a through portion that allows the magnetic force to pass through the passage.

The vane and the through portion may be arranged in a rotation direction of the adjustment member.

The present invention may further include a motor that rotates the cooling fan, and a support casing coupled with the motor.

The operation detecting module may be disposed in a space surrounded by the motor and the support casing.

The present invention may further include a motor disposed between the cooling fan and the operation detecting module and rotating the cooling fan and the adjustment member.

The cooling fan may be connected to a shaft of the motor on one side of the motor, and the adjustment member may be connected to the shaft on the other side of the motor.

The operation detecting module may be disposed in a space surrounded by the motor and the support casing.

The magnetic member may be coupled to the motor, the detector may be coupled to the support casing, and the adjustment member may be disposed between the magnetic member and the detector and coupled to the shaft.

The magnetic member, the adjustment member, and the detector may be arranged in a row along a longitudinal direction of the shaft, and the adjustment member may be disposed between the magnetic member and the detector.

The support casing may include an accommodating portion that accommodates the operation detecting module therein, and a coupling portion that couples the accommodating portion to the motor.

The detector may be installed on a board coupled to the support casing inside the accommodating portion, the magnetic member may be coupled to the motor, and the adjustment member may be disposed between the magnetic member and the detector inside the accommodating portion.

The present invention may further include a controller that controls the operation of the heater using a result of monitoring the number of alternations of the first operation and the second operation for each unit time.

The controller may stop the operation of the heater when the number of alternations of the first operation and the second operation for each unit time is smaller than a set value.

A cooling unit according to another aspect of the present invention may include a cooling fan that rotates and generates a flow of cold air, and an operation detecting module that senses the rotation of the cooling fan.

The operation detecting module may be connected to a device including a controller that controls an operation of the device based on a magnitude of an electromotive force, and may be connected to the controller such that the number of alternations of the first operation and the second operation for each unit time is measured by the controller.

According to the cooking appliance and the cooling unit disposed therein of the present invention, whether the failure has occurred in the cooling fan may be determined based on the result of measuring the number of alternations for each unit time by the operation detecting module, so that whether the failure has occurred in the cooling fan may be quickly identified.

In addition, according to the present invention, when the electrical components are not properly cooled because of the failure of the cooling fan, this may be quickly identified and the cooking operation may be stopped, so that the electrical components may be protected from the failure resulted from the overheating.

In addition, according to the present invention, the operation detecting module is constructed by the magnetic member formed in the shape of the ring magnet with the simple structure and the adjustment member formed in the shape of the rotating body that has a lower density than the magnet and is not eccentric, so that the cooking appliance that effectively protects the electrical components from the failure resulted from the overheating while suppressing the increases in the size and the weight of the operation detecting module, as well as the increases in the manufacturing cost and the manufacturing time may be provided.

In addition, the present invention may acquire the information necessary to determine whether the cooling fan module has stopped operating, regardless of whether the motor that operates the cooling fan is the AC motor or the DC motor, thereby effectively identifying whether the failure has occurred in the cooling fan module.

### BRIEF DESCRIPTION OF DRAWINGS

FIG. 1 is a front perspective view showing a cooking appliance according to an embodiment of the present invention.
FIG. 2 is a side cross-sectional view showing an internal configuration of a cooking appliance shown in FIG. 1.
FIG. 3 is an enlarged view of a portion "III" in FIG. 2.
FIG. 4 is a diagram showing a flow of cold air in a cooking appliance shown in FIG. 2.
FIG. 5 is a perspective view separately showing a cooling unit shown in FIG. 3.
FIG. 6 is a front cross-sectional view showing an internal structure of a cooling unit shown in FIG. 5.
FIGS. 7 and 8 are exploded perspective views showing a disassembled state of an operation detecting module shown in FIG. 5.
FIGS. 9 and 10 are cross-sectional views showing a state in which an operation detecting module operates in a first operation according to an embodiment of the present invention. More specifically, Fig. 9 is a front cross-sectional view showing an internal structure of the cooling unit, while Fig. 10 is a side cross-sectional view showing a portion of the operating detecting module.
FIGS. 11 and 12 are front cross-sectional views showing a state in which an operation detecting module operates in a second operation according to an embodiment of the present invention. More specifically, Fig. 11 is a front cross-sectional view showing an internal structure of the cooling unit, while Fig. 12 is a side cross-sectional view showing a portion of the operating detecting module.
FIG. 13 is a graph showing a signal output state of a hall sensor when a cooling unit operates according to an embodiment of the present invention.
FIG. 14 is a diagram schematically showing a configuration of a cooking appliance according to an embodiment of the present invention.
FIG. 15 is a flowchart schematically showing a control process of a cooking appliance according to an embodiment of the present invention.

### DETAILED DESCRIPTIONS

The above-mentioned purposes, features, and advantages will be described in detail later with reference to the attached drawings, so that those skilled in the art in the technical field to which the present invention belongs may easily implement the technical ideas of the present invention. In describing the present invention, when it is determined that a detailed description of the publicly known technology related to the present invention may unnecessarily obscure the gist of the present invention, the detailed description will be omitted. Hereinafter, a preferred embodiment according to the present invention will be described in detail with reference to the attached drawings. In the drawings, identical reference numerals are used to indicate identical or similar components.

Although first, second, and the like are used to describe various components, these components are not limited by such terms. Such terms are only used to distinguish one component from another component, and unless specifically stated to the contrary, a first component may also be a second component.

The present invention may not be limited to embodiments disclosed below, and various changes may be made and the present invention may be implemented in various different forms. The present embodiment is provided solely to ensure that the disclosure of the present invention is complete and to fully inform those skilled in the art of the scope of the invention. Therefore, it should be understood that the present invention is not limited to the embodiments disclosed below, but includes all changes, or substitutes included in the technical idea and the scope of the present invention, as well as substitution of components of one embodiment with components of another embodiment and addition of components.

The attached drawings are only for easy understanding of the embodiments disclosed herein, and the technical ideas disclosed herein are not limited by the attached drawings. Further, it should be understood that the present invention includes all modifications, or substitutions that fall within the technical concept and scope of the present invention. In drawings, components may be expressed exaggeratedly large or small in size or thickness for convenience of understanding or the like, but the scope of protection of the present invention should not be interpreted as limited by the same.

The terms used herein are merely used to describe specific implementations or embodiments, and are not intended to limit the present invention. Further, singular expressions include plural expressions, unless the context clearly dictates otherwise. Herein, terms such as "include", "composed of", and the like are intended to indicate the existence of features, numbers, steps, operations, components, parts, or combinations thereof described herein. That is to say, it should be understood that terms such as "include", "composed of', and the like as used herein do not exclude in advance the presence or addition of one or more other features, numbers, steps, operations, components, parts, or combinations thereof.

Terms including ordinal numbers, such as first, second, and the like, may be used to describe various components, but the components are not limited by the terms. The above terms are used only for the purpose of distinguishing one component from another.

When a first component is described as being "connected" or "coupled" to a second component, it should be understood that the components may be directly connected or coupled to each other, but a third component may be interposed between the components. On the other hand, when it is described that the first component is "directly connected" or "directly coupled" to the second component, it should be understood that there are no other components interposed therebetween.

When a first component is described to be "on top of" or "under" a second component, it is understood that the first component may be disposed in contact with a top surface (or a bottom surface) of the second component, as well as a third component may be interposed therebetween.

Unless otherwise defined, all terms used herein, including technical or scientific terms, have the same meaning as commonly understood by a person of ordinary skill in the technical field to which the present invention pertains. Terms defined in commonly used dictionaries should be interpreted as having a meaning consistent with the meaning in the context of the related technology, and unless explicitly defined in the present application, should not be interpreted in an ideal or excessively formal sense.

When a cooking appliance is placed on the floor for use, a side on which a door is installed, relative to a center of the cooking appliance is defined as a front side. Therefore, a direction of opening the door and entering the cooking appliance becomes a rearward direction. For convenience, a direction between the front side and a rear side may be referred to as a first direction. Then, the front side may be referred to as one side in the first direction, and the rear side may be referred to as the other side in the first direction.

Additionally, the direction of gravity may be defined as a downward direction, and a direction opposite to the direction of gravity may be defined as an upward direction.

In addition, a horizontal direction orthogonal to the front and rear direction of the cooking appliance, that is, a width direction of the cooking appliance when viewing the cooking appliance in front of the door thereof, may be referred to as a left and right direction. For convenience, the left and right direction may be referred to as a second direction. Thus, a right side may be referred to as one side in the second direction, and a left side may be referred to as the other side in the second direction.

In addition, the vertical direction described above may be referred to as a third direction. Then, an upper side may be referred to as one side in the third direction, and a lower side may be referred to as the other side in the third direction.

Throughout the present document, "A and/or B" means A, B, or A and B, unless otherwise specified, and "C to D" means equal to or greater than C and equal to or smaller than D unless otherwise specified.

### [Overall structure of cooking appliance]

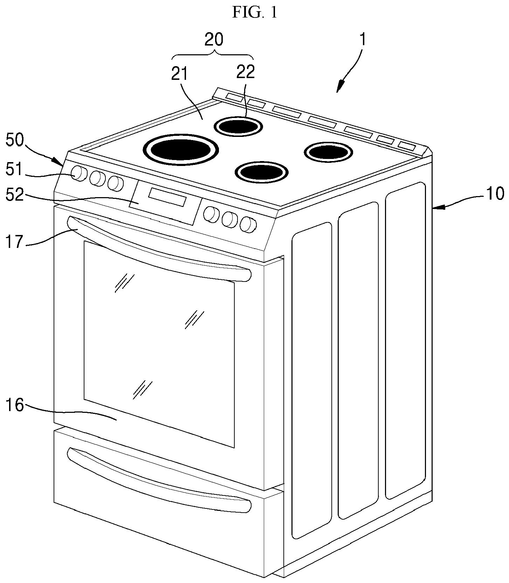

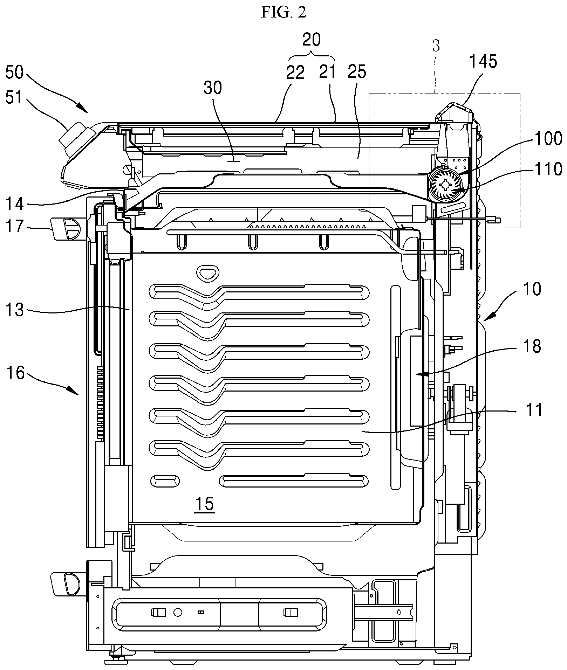

FIG. 1 is a front perspective view showing a cooking appliance according to an embodiment of the present invention, and FIG. 2 is a side cross-sectional view showing an internal configuration of a cooking appliance shown in FIG. 1.

Referring to FIGS. 1 and 2, an outer appearance of a cooking appliance 1 is formed by a main body 10. The main body 10 may have a substantially rectangular parallelepiped shape and may be made of a material with a predetermined strength to protect multiple components installed in an internal space thereof.

The main body 10 may be composed of a cavity 11 that forms a skeleton of the main body 10, and a front panel 13 that is disposed in front of the cavity 11 and forms a front surface of the main body 10. A cooking chamber 15 is formed inside the cavity 11, and an opening that opens the cooking chamber 15 forward is defined inside the front panel 13.

A cooktop 20 constructed to cook food by heating the food or a container containing the food may be disposed at an upper portion of the main body 10. The cooktop 20 may be provided with a top plate 21 that closes an upper end of the main body 10 while forming a top surface outer appearance.

At least one heater 22 for heating the food to be cooked or the container containing the food may be disposed at a center of the cooktop 20. For example, the heater 22 may be constructed as an induction heater using electricity.

As another example, the heater 22 may be constructed as a heating device using a gas fuel. A structure of the heater 22 may be changed depending on a type of heat source used.

Inside the main body 10, the cooking chamber 15 may be formed. The cooking chamber 15 has a shape of a cube with an open front surface, and the food is cooked as the internal space of the cooking chamber 15 is heated while the cooking chamber 15 is shielded. That is, in the cooking appliance 1, the internal space of the cooking chamber 15 is a space where the food is being cooked.

The cooking appliance 1 has a heater that heats the cooking chamber 15. As an example of such a heater, a convection unit 18 that directs hot air to heat the internal space of the cooking chamber 15 may be disposed at the rear of the cooking chamber 15 as the heater. Additionally, an upper heater that heats the internal space of the cooking chamber 15 from above may be disposed above the cooking chamber 15 as the heater. Additionally, a lower heater that heats the internal space of the cooking chamber 15 from below may be disposed below the cooking chamber 15 as the heater.

A door 16 that selectively opens and closes the cooking chamber 15 may be pivotably disposed at a front portion of the main body 10. The door 16 may open and close the cooking chamber 15 using a pull-down scheme in which an upper end thereof pivots in a vertical direction around a lower end thereof.

Such door 16 is formed in a shape of a hexahedron with a constant predetermined thickness. A handle 17 is installed on a front surface of the door 16 to be gripped when a user wants to pivot the door 16.

A control panel 50 may be disposed at an upper portion of the front surface of the cooking appliance 1, that is, at an upper front surface of the cavity 11. The control panel 50 may form a portion of a front surface outer appearance of the cooking appliance 1. Such control panel 50 may have a knob 51 for adjusting operation of the cooking appliance 1, a display 52 for displaying an operating state of the cooking appliance 1, and the like.

An electrical component chamber 30 may be disposed outside of the cavity 11. The electrical component chamber 30 may be disposed above the cavity 11 and behind the control panel 50. Inside the electrical component chamber 30, a space for electrical components to be installed may be defined.

A front surface of the electrical component chamber 30 may be shielded by the front panel 13. The front panel 13 may be disposed between the cavity 11 and the door 16. At least a portion of such front panel 13 may be disposed to block a front surface of the electrical component chamber 30. For example, an upper area of the front panel 13 disposed upwardly of the cooking chamber 15 may shield the front surface of the electrical component chamber 30.

An intake port 14 may be disposed on the front panel 13. The intake port 14 may be formed to be penetrated in a front and rear direction on the front panel 13. Such intake port 14 may define a passage for air from outside the electrical component chamber 30 to flow into the electrical component chamber 30 on the front panel 13.

### [Internal structure of electrical component chamber]

Top, side, rear boundary surfaces of the electrical component chamber 30 may be defined by an electrical component chamber cover 25 that covers the electrical component chamber 30 from above. In addition, a bottom boundary surface of the electrical component chamber 30 may be defined by a top surface of the cavity 11. As an example, the electrical component chamber cover 25 may be formed in a hexahedral shape with open front and bottom surfaces.

As another example, the both side and rear boundary surfaces of the electrical component chamber 30 may be defined by the electrical component chamber cover 25, and the top boundary surface of the electrical component chamber 30 may be defined by a base plate that defines a bottom boundary surface of the cooktop 20.

As described above, the various electrical components may be disposed inside the electrical component chamber 30. As an example, a circuit board may be disposed inside the electrical component chamber 30. Various elements, circuits, and the like related to reception of a manipulation signal input via the control panel 50, generation of a control signal for controlling an operation of the heater, and the like may be disposed on the circuit board.

The circuit board may be disposed above the cavity 11. Such circuit board may be supported by a supporter installed at the top of the cavity 11. For example, the supporter may be installed at the top of the cavity 11, and the circuit board may be coupled to the supporter at a location spaced upwardly apart from the cavity 11, so that the circuit board may be disposed to be spaced apart from the cavity 11 by a predetermined distance.

A space through which air may flow is defined inside the electrical component chamber 30 where the electrical components are disposed as described above. The internal space of the electrical component chamber 30 may be connected to the intake port 14 formed on the front panel 13. That is, the intake port 14 may define the passage for air from outside the cooking appliance 1 to flow into the electrical component chamber 30 on the front panel 13.

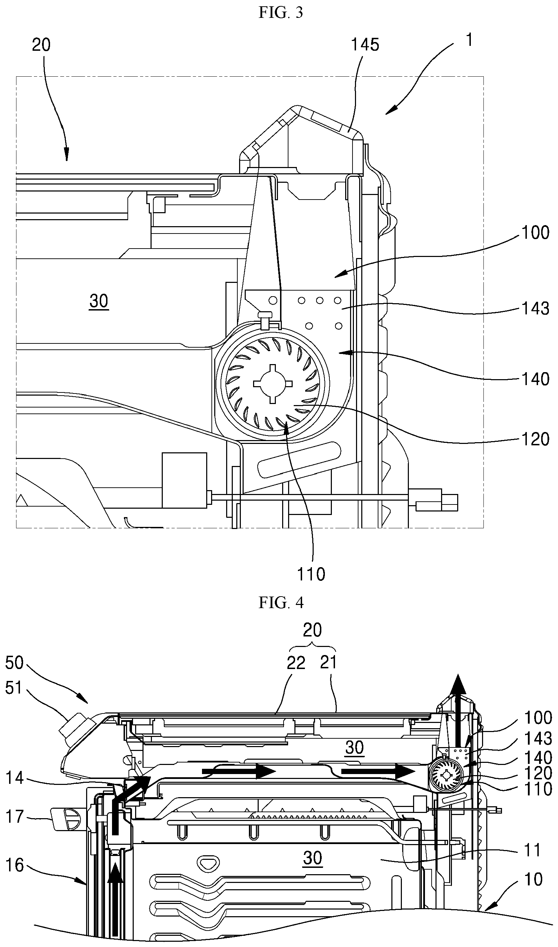

FIG. 3 is an enlarged view of a portion "III" in FIG. 2, and FIG. 4 is a diagram showing a flow of cold air in a cooking appliance shown in FIG. 2.

Referring to FIGS. 2 and 3, a cooling unit 100 may be disposed in the electrical component chamber 30, adjacent to a rear surface of the cavity 11. Such cooling unit 100 may include a cooling fan 120.

The cooling fan 120 may include a turbo fan installed on the top surface of the cavity 11. Such cooling fan 120 may suck air in front of the electrical component chamber 30 and discharge the sucked air into a rear space of the cooking chamber 15.

In addition, a lower through-hole that is in communication with the rear space of the cooking chamber 15 and is open forward may be defined at a front lower portion of the main body 10.

Therefore, when the cooling fan 120 operates, as shown in FIG. 4, outside air at a front lower portion of the main body 10 flows into the door 16 via an air flow hole defined at a bottom of the door 16 and rises. In such process, the heated door 16 may be cooled by heat transferred from the cooking chamber 15 to the door 16.

The air that has risen inside the door 16 may flow into the electrical component chamber 30 via an air flow hole defined at a top of the door 16 and the intake port 14 formed to be penetrated on the front panel 13. As such, air that has flowed into the electrical component chamber 30 may be sucked toward the cooling fan 120 and cool the electrical components disposed in the electrical component chamber 20, then may be discharged to the rear space of the cooking chamber 15, and then may be discharged to the outside of the cooking appliance 1.

### [Structure of cooling unit]

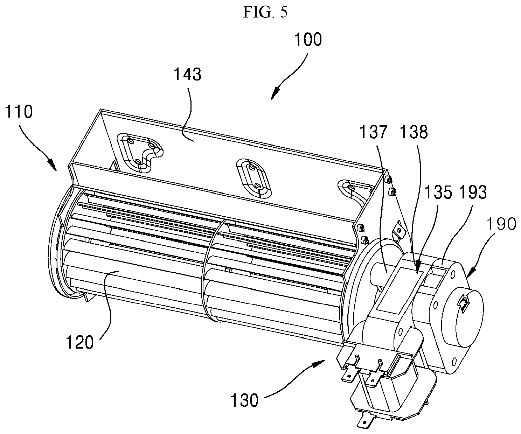

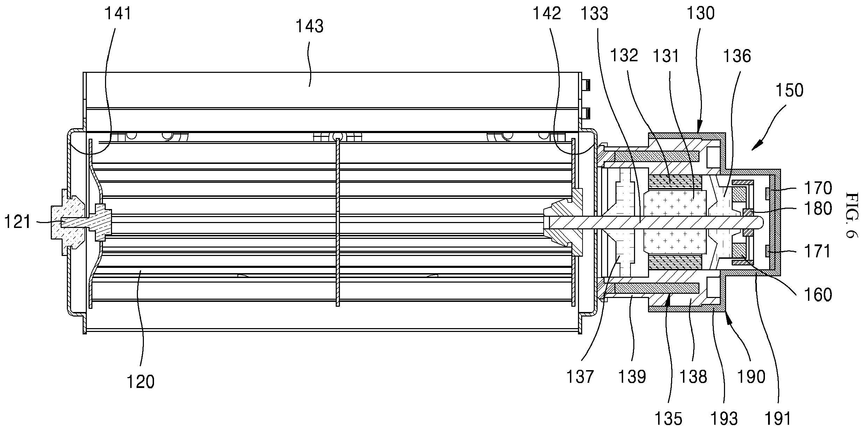

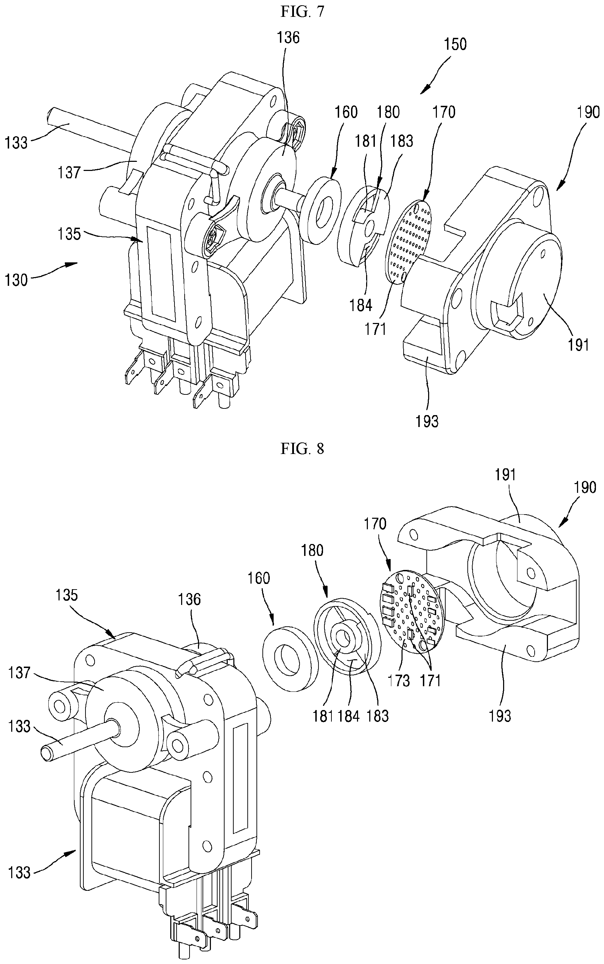

FIG. 5 is a perspective view separately showing a cooling unit shown in FIG. 3, and FIG. 6 is a cross-sectional view taken along a line "VI-VI" in FIG. 5. In addition, FIG. 7 is an exploded perspective view showing a disassembled state of an operation detecting module shown in FIG. 5, and FIG. 8 is a cross-sectional view taken along a line "VIII-VIII" in FIG. 7.

Referring to FIGS. 4 to 6, the cooling unit 100 may include a cooling fan module 110. The cooling fan module 110 may be disposed to cool the electrical component disposed inside the electrical component chamber 30. Such cooling fan module 110 may include a motor 130 and the cooling fan 120.

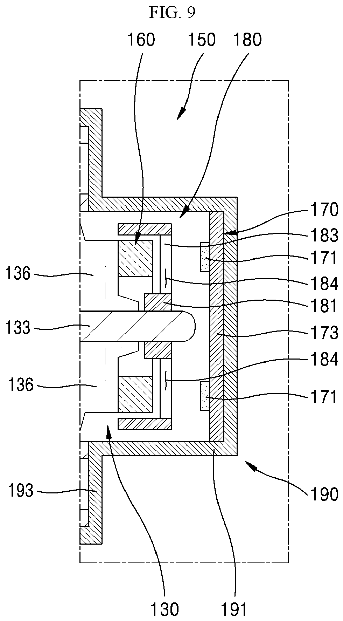

Operation of the motor 130 may be controlled by a controller 200 (see FIG. 9) disposed in the cooking appliance 1. The motor 130 may include a rotor, a stator, and a shaft 133 connected to the rotor and rotatable. Such motor 130 may be connected to the cooling fan 120 via the shaft 133 and may operate the cooling fan 120.

The cooling fan 120 is connected to the shaft 133 and rotates together with the shaft 133. Such cooling fan 120 may be operated by the shaft 133, and may rotate together with the shaft 133 to generate the flow of cold air.

The cooling fan module 110 may further include a fan housing 140. The fan housing 140 may accommodate at least a portion of the cooling fan 120 therein and may rotatably support the shaft 133.

As an example, the fan housing 140 may include fan supports 141 and 142 disposed on both sides of the cooling fan 120 along a longitudinal direction of the shaft 133 (hereinafter, referred to as the "longitudinal direction"). The cooling fan 120 may be disposed between the pair of fan supports 141 and 142. In addition, the shaft 133 connected to such cooling fan 120 may be rotatably supported by at least one of the pair of fan supports 141 and 142.

For example, the cooling fan 120 may be rotatably supported by one, the fan support 141, of the pair of fan supports 141 and 142. In this regard, the cooling fan 120 may have a protruding shaft 121 formed to protrude from the cooling fan 120. As such protruding shaft 121 is rotatably coupled to the fan support 141, one side in the longitudinal direction of the cooling fan 120 may be rotatably supported by the fan support 141.

In addition, the shaft 133 may be rotatably supported by the other, the fan support 142 that is closer to the motor 130, of the pair of fan supports 141 and 142. As a result, the other side in the longitudinal direction of the cooling fan 120 connected to the shaft 133 may be rotatably supported by the fan support 142.

The motor 130 may be coupled to the fan support 142, which is closer to motor 130, among the pair of fan supports 141 and 142. As such, the motor 130 coupled to the fan support 142 may further include a motor casing 135.

The motor casing 135 may accommodate the rotor and the stator therein, and may rotatably support the shaft 133. Such motor casing 135 may include a first shaft support 136 and a second shaft support 137.

The first shaft support 136 may be disposed between the rotor and the stator accommodated inside the motor casing 135 and an operation detecting module 150 to be described later. Such first shaft support 136 may rotatably support the other side in the longitudinal direction of the shaft 133 adjacent to the operation detecting module 150.

The second shaft support 137 may be disposed between the rotor and the stator accommodated inside the motor casing 135 and the cooling fan 120. Such second shaft support 137 may rotatably support one side in the longitudinal direction of the shaft 133 adjacent to the cooling fan 120.

The shaft 133 may be rotatably supported by the motor casing 135 while extending through the motor casing 135. One side in the longitudinal direction of such shaft 133 may protrude outwardly of the motor casing 135 through the second shaft support 137 and may be connected to the cooling fan 120 through the fan support 142.

In addition, the other side in the longitudinal direction of the shaft 133 may protrude outwardly of the motor casing 135 through the first shaft support 136 and may be connected to the operation detecting module 150 on the outside of the motor casing 135.

The first shaft support 136 and the second shaft support 137 may be disposed to be spaced apart from each other along the longitudinal direction of the shaft 133, and the first shaft support 136 and the second shaft support 137 spaced apart from each other as such may be connected to each other by connection supports 138 and 139.

The connection supports 138 and 139 may be formed in a shape that surrounds the rotor, the stator, and the shaft 133 from the outside in a radial direction of the shaft 133. One side in the longitudinal direction of each of such connection supports 138 and 139 may be connected to the second shaft support 137, and the other side in the longitudinal direction of each of such connection supports 138 and 139 may be connected to the first shaft support 136.

In one example, a flow duct 143 may be disposed in the fan housing 140. The flow duct 143 may be disposed on top of the cooling fan 120. In the present embodiment, the flow duct 143 is illustrated as being disposed on top of the cooling fan 120 to be in communication with an outlet of the cooling fan 120. Such flow duct 143 may provide a coupling surface for fixing the cooling fan module 110 to the fan housing 140 while guiding a flow of gas discharged from the cooling fan 120.

For example, the flow duct 143 may be formed in a shape of a box with an open top. Such flow duct 143 may be disposed on the fan supports 141 and 142 and connected to the pair of fan supports 141 and 142, and an upper portion of the flow duct 143 may be open toward an exhaust 145 disposed on the flow duct 143.

Accordingly, an outlet of the flow duct 143 may be connected to the exhaust 145 disposed on the flow duct 143. In the exhaust 145, an exhaust port that allows the outlet of the flow duct 143 to be in communication with the outside of the cooking appliance 1 may be formed to be penetrated in the vertical direction. Air sucked into the cooling fan 120 after passing through the electrical component chamber 30 may flow toward the exhaust 145 while being guided by the flow duct 143.

That is to say, air introduced into the electrical component chamber 30 by the airflow formed via the cooling fan 120 may be sucked by the cooling fan 120 and then finally discharged to the outside of the cooking appliance 1 via the exhaust 145.

In addition, a rear surface of the flow duct 143 facing a rear surface of the electrical component chamber cover 25 may become the coupling surface for coupling between the fan housing 140 and the electrical component chamber cover 25. The cooling unit 100 may be stably fixed inside the electrical component chamber 30 via the coupling between the fan housing 140 and the electrical component chamber cover 25 as described above.

In one example, referring to FIGS. 5 to 8, the cooling unit 100 in the present embodiment may further include the operation detecting module 150. The operation detecting module 150 may sense the rotation of the cooling fan 120, and accordingly, monitor an operating state of the cooling fan 120.

### [Structure of operation detecting module]

The operation detecting module 150 may include a magnetic member 160. The magnetic member 160 is disposed to generate a magnetic force. As an example, the magnetic member 160 may include a permanent magnet, and may be disposed between the motor 130 and a detector 170, which will be described later.

Components that constitute the cooling unit 100 may be divided into rotating components that rotate by the shaft 133 and fixed components that do not rotate by the shaft 133. The cooling fan 120 rotated by the motor 130 may correspond to the rotating component, and the fan housing 140, the magnetic member 160, and the like may correspond to the fixed components. That is, the magnetic member 160 is provided in a fixed form in the operation detecting module 150 and does not rotate together with the cooling fan 120.

As an example, the magnetic member 160 may include a permanent magnet formed in a ring shape. That is, the magnetic member 160 may be provided in the shape of the ring surrounding the shaft 133 from the outside in a circumferential direction. Accordingly, the other side in the longitudinal direction of the shaft 133 may protrude outwardly of the motor casing 135 through the first shaft support 136 and the magnetic member 160.

One side surface of the magnetic member 160 may be disposed to face the motor 130. In addition, the other side surface of the magnetic member 160 may be disposed to face the detector 170. As an example, the magnetic member 160 may be magnetized in a single-sided two-pole form. For example, the one side surface of the magnetic member 160 facing the motor 130 may be an S pole, and the other side surface of the magnetic member 160 facing the detector 170 may be an N pole.

In the present embodiment, the magnetic member 160 is illustrated as being installed on the motor 130. Accordingly, the magnetic member 160 may be coupled to the motor casing 135. As an example, the motor casing 135 may be made of a ferromagnetic body, and the coupling between the magnetic member 160 and the motor casing 135 may be achieved in a form of the motor casing 135 and the magnetic member 160 being attached to each other by the magnetic force generated by the magnetic member 160.

More specifically, the magnetic member 160 may be coupled to the first shaft support 136 adjacent to the shaft 133. In this case, only the first shaft support 136 of the motor casing 135 may be made of a ferromagnetic body, and the coupling between the magnetic member 160 and the motor casing 135 may be achieved in a form of such first shaft support 136 and the magnetic member 160 being attached to each other.

The operation detecting module 150 may further include the detector 170. The detector 170 may sense the magnetic force generated by the magnetic member 160. As an example, the detector 170 may include at least one hall sensor 171.

The hall sensor 171 may be installed on aboard 173, may sense the magnetic force of the magnetic member 160 that is adjacent thereto and within a predetermined distance, and generate a signal corresponding to the sensed magnetic force.

In the present embodiment, it is illustrated that a plurality of hall sensors 171 are arranged to be spaced apart from each other by a predetermined spacing along a rotation direction of the shaft 133. However, the present invention may not be limited thereto, and only one hall sensor 171 may be disposed to sense the magnetic force generated by the magnetic member 160.

The detector 170 may be disposed further away from the motor 130 than the magnetic member 160. That is, the magnetic member 160 may be disposed between the motor 130 and the detector 170.

Additionally, the operation detecting module 150 may further include an adjustment member 180. The adjustment member 180 may be disposed to open and close a passage through which the magnetic force passes at the location between the magnetic member 160 and the detector 170.

In the present embodiment, the passage may be defined as an area that connects the magnetic member 160 with the detector 170 among areas where the magnetic force of the magnetic member 160 is applied.

According to the present embodiment, the magnetic member 160, the adjustment member 180, and the detector 170 may be arranged in a line along the longitudinal direction of the shaft 133. In addition, the adjustment member 180 may be disposed between the magnetic member 160 and the detector 170. When the cooling fan 120 rotates, the adjustment member 180 may operate such that a first operation to open the passage and a second operation to close the passage are alternately performed in a repeated manner.

The adjustment member 180 may rotate in association with the rotation of the cooling fan 120. Such adjustment member 180 may include a coupling shaft 181 that is coupled to the shaft 133 and rotates together with the shaft 133.

As such, by the rotation of the adjustment member 180 coupled to the shaft 133, the operation of the adjustment member 180 may be changed from the first operation to the second operation or from the second operation to the first operation. In the present embodiment, it is illustrated that the adjustment member 180 rotates together with the shaft 133 and the operation of the adjustment member 180 changes periodically.

Additionally, the adjustment member 180 may further include a vane 183. The vane 183 may be connected to the coupling shaft 181 and may rotate together with the coupling shaft 181. As an example, the vane 183 may be disposed between the magnetic member 160 and the detector 170 and may protrude in a centrifugal direction from the coupling shaft 181. Such vane 183 may block the passage between the magnetic member 160 and the detector 170.

As an example, the vane 183 may be made of a ferromagnetic body that may block the magnetic force of the magnetic member 160 from being transmitted to the detector 170 at the location between the magnetic member 160 and the detector 170.

The vane 183 may rotate in association with the rotation of the cooling fan 120, and accordingly, the location of the vane 183 may be continuously changed. For example, the location of the vane 183 may be changed to a first location that blocks the passage and a second location that does not block the passage.

The vane 183 may rotate in association with the rotation of the cooling fan 120 and may circulate between the first location and the second location. When the vane 183 is at the first location, the adjustment member 180 may operate in the first operation. In addition, when the vane 183 is at the second position, the adjustment member 180 may operate in the second operation.

That is, when the vane 183 is at the first location, the adjustment member 180 operates in the first operation, thereby opening the passage such that the magnetic force of the magnetic member 160 may be sensed by the detector 170. In addition, when the vane 183 is at the second location, the adjustment member 180 operates in the second operation, thereby closing the passage such that the magnetic force of the magnetic member 160 may not be sensed by the detector 170.

In the present embodiment, the adjustment member 180 is illustrated as including the vane 183 and a through portion 184. In the adjustment member 180, the vane 183 and the through portion 184 may be arranged in a rotation direction of the adjustment member 180.

The vane 183 is disposed to block the magnetic force in the passage. When such vane 183 is at the second location, the vane 183 may close the passage and act such that the magnetic force of the magnetic member 160 is not sensed by the detector 170.

The through portion 184 is defined to allow the magnetic force to pass through the passage. As an example, the through portion 184 may be defined as a portion of the adjustment member 180 where the vane 183 is not disposed.

In the present embodiment, it is illustrated that a pair of vanes 183 and a pair of through portions 184 are arranged in the adjustment member 180, and the vanes 183 and the through portions 184 are arranged alternately along the rotation direction of the adjustment member 180. Accordingly, the pair of vanes 183 may be disposed in the adjustment member 180 to be spaced apart from each other by a predetermined spacing along the rotation direction of the adjustment member 180, and the through portions 184 may be disposed between the vanes.

As another example, in the adjustment member 180, which is entirely formed in a disk shape, each of the vane 183 and the through portion 184 may be disposed in a semicircular shape.

In one example, the cooling unit 100 in the present embodiment may further include a support casing 190. The support casing 190 may accommodate at least a portion of the operation detecting module 150 therein and may be coupled to the motor 130.

According to the present embodiment, the cooling fan 120 may be disposed on one side of the motor 130, and the operation detecting module 150 may be disposed on the other side of the motor 130. In addition, the support casing 190 may be disposed on the other side of the motor 130 and coupled with the motor 130. At least a portion of the operation detecting module 150 disposed on the other side of the motor 130 together with the support casing 190 may be disposed in a space surrounded by the motor 130 and the support casing 190.

In the present embodiment, the magnetic member 160, the adjustment member 180, and the detector 170 are illustrated as being accommodated inside the support casing 190 with the motor 130 or disposed in a space surrounded by the support casing 190.

As an example, the support casing 190 may include an accommodating portion 191 and a coupling portion 193. The accommodating portion 191 is disposed to accommodate the operation detecting module 150 therein, and the coupling portion 193 is disposed to couple the accommodating portion 191 to the motor 130.

As an example, the accommodating portion 191 may be formed in a hollow cylindrical shape. Such accommodating portion 191 may accommodate therein the adjustment member 180, which is formed in an approximately disk shape, and the adjustment member 180 may rotate together with the shaft 133 inside the accommodating portion 191.

Additionally, the detector 170 may also be accommodated in the accommodating portion 191 together. As an example, the board 173 of the detector 170 may be formed in a disk shape similar to the shape of the adjustment member 180. Such board 173 may be installed inside the accommodating portion 191. For example, the board 173 may be installed inside the accommodating portion 191 in a form coupled to an inner surface of the accommodating portion 191.

The magnetic member 160 may be accommodated inside the accommodating portion 191 or may be disposed outside the accommodating portion 191. The adjustment member 180 may be disposed between the magnetic member 160 and the detector 170 inside the accommodating portion 191.

The coupling portion 193 may support the accommodating portion 191 and may be coupled to the other side of the motor 130. Such coupling portion 193 may be disposed between the motor 130 and the accommodating portion 191, and may be formed integrally with the accommodating portion 191. The coupling portion 193 may be coupled to the motor casing 135 via a screw or the like, and the coupling between the motor 130 and the support casing 190 may be achieved via such coupling between the coupling portion 193 and the motor casing 135.

### [Operation of operation detecting module]

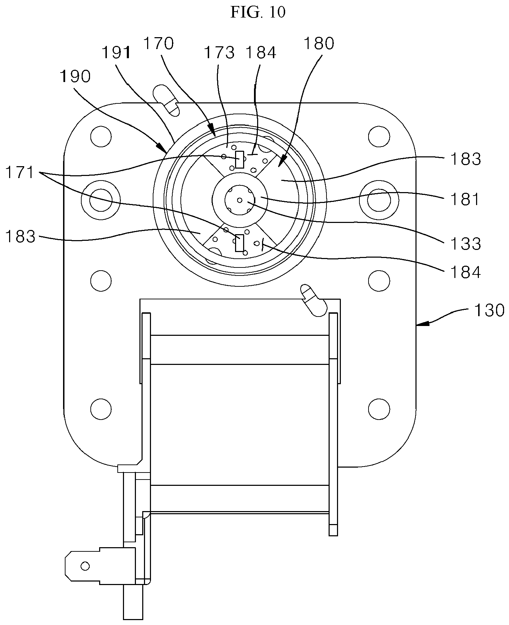

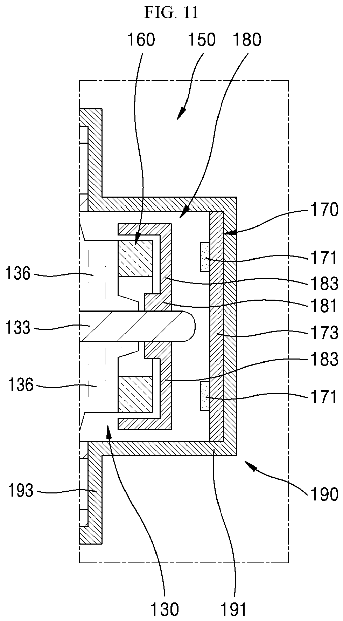

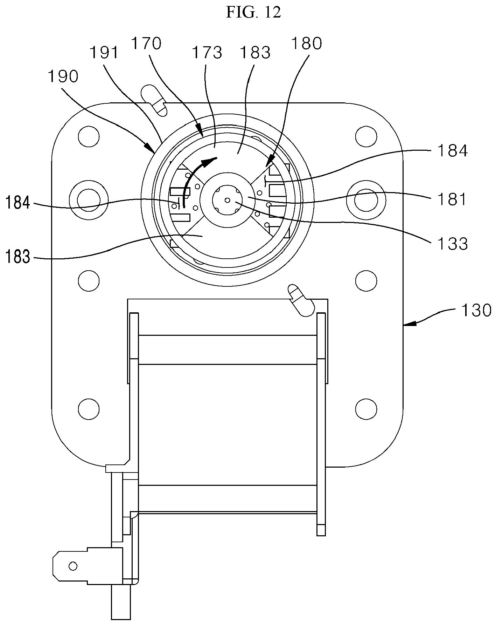

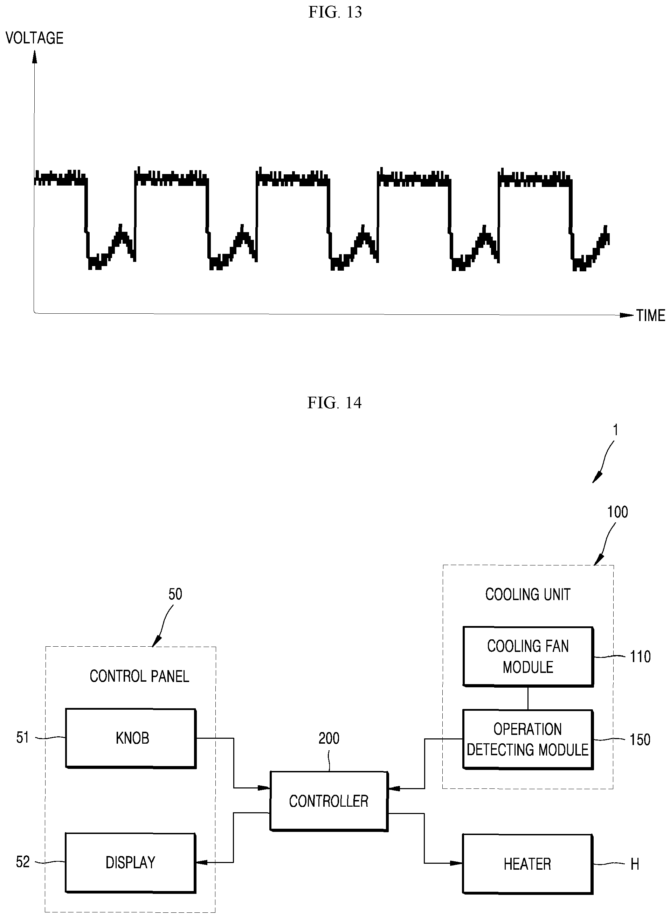

FIGS. 9 and 10 are cross-sectional views showing a state in which an operation detecting module operates in a first operation according to an embodiment of the present invention, FIGS. 11 and 12 are front cross-sectional views showing a state in which an operation detecting module operates in a second operation according to an embodiment of the present invention, and FIG. 13 is a graph showing a signal output state of a hall sensor when a cooling unit operates according to an embodiment of the present invention. In this regard, FIGS. 9 and 11 are front cross-sectional views showing an internal structure of the cooling unit, and FIGS. 10 and 12 are side cross-sectional views showing a portion of the operation detecting module.

In the cooling unit 100 as shown in FIGS. 9 and 10, the cooling fan 120 and the adjustment member 180 are connected to the shaft 133 disposed in the motor 130. The cooling fan 120 may be connected to one side of the shaft 133, the adjustment member 180 may be connected to the other side of the shaft 133, and the cooling fan 120 and the adjustment member 180 may rotate together by the shaft 133 when the motor 130 operates.

That is to say, the adjustment member 180 may rotate in association with the rotation of the cooling fan 120. As such, the operation of the adjustment member 180, which rotates together with the cooling fan 120, may be changed periodically. While the adjustment member 180 rotates, the operation of the adjustment member 180 may be repeatedly changed from the first operation to the second operation and again from the second operation to the first operation.

In the present embodiment, it is illustrated that a pair of hall sensors 171 are disposed on the detector 170. Additionally, in the present embodiment, it is illustrated that the pair of vanes 183 and the pair of through portions 184 are disposed in the adjustment member 180 and the vanes 183 and the through portions 184 are arranged alternately along the rotation direction of the adjustment member 180.

Accordingly, the pair of vanes 183 and the pair of through portions 184 may be arranged at point-symmetrical locations around the coupling shaft 181, and the pair of hall sensors 171 may also be arranged at point-symmetrical locations around the coupling shaft 181.

For example, the pair of vanes 183 and the pair of through portions 184 may be arranged such that an angle between the vanes 183 or an angle between the through portions 184 centered on the coupling shaft 181 is 90 °. Further, the pair of hall sensors 171 may be arranged such that an angle therebetween centered on the coupling shaft 181 is 180 °.

When the vane 183 is at the first location while the adjustment member 180 is rotating, the adjustment member 180 may operate in the first operation. As such, the adjustment member 180, which operates in the first operation, may open the passage such that the magnetic force of the magnetic member 160 may be sensed by the detector 170. At this time, the magnetic member 160, the through portion 184, and the hall sensor 171 may be connected to each other in a straight line.

That is, all of the hall sensors 171 may be connected in the straight line to the magnetic member 160 and the through portion 184. Therefore, all of the hall sensors 171 may sense the magnetic force of the magnetic member 160.

As shown in FIGS. 11 to 13, when the rotation of the cooling fan 120 and the adjustment member 180 continues and the location of the vane 183 changes to the second location, the adjustment member 180 may operate in the second operation. As such, the adjustment member 180, which operates in the second operation, may close the passage such that the magnetic force of the magnetic member 160 is not sensed by the detector 170. At this time, the magnetic member 160, the vane 183, and the hall sensor 171 may be connected to each other in a straight line.

At this time, all of the hall sensors 171 may be connected in the straight line to the magnetic member 160 and the vane 183. That is, the magnetic force of the magnetic member 160 is not sensed by any hall sensor 171.

As the rotation of the cooling fan 120 and the adjustment member 180 continues, the location of the vane 183 may change repeatedly, changing back to the first location and then to the second location, and accordingly, the change in the operation of the adjustment member 180 may be repeated continuously while the rotation of the cooling fan 120 and the adjustment member 180 continues.

As the operation of the adjustment member 180 progresses in the above manner, in each hall sensor 171, the state of sensing the magnetic force of the magnetic member 160 and the state of not sensing the magnetic force of the magnetic member 160 may be alternately performed in a repeated manner.

As an example, the other side surface of the magnetic member 160 facing the detector 170 may be provided as the N pole. In addition, the adjustment member 180, especially the vane 183, may be made of the ferromagnetic body and may block the magnetic force of the magnetic member 160 between the magnetic member 160 and the detector 170.

When the magnetic force of the magnetic member 160 is sensed by the hall sensor 171, the hall sensor 171 may output a signal with a voltage of about 5.2 V. When the magnetic force is not sensed by the hall sensor 171, the hall sensor 171 may output a signal at a voltage equal to or lower than about 0.6 V.

That is to say, when the adjustment member 180 is adjusted in the first operation, the hall sensor 171 may output the signal with the voltage of about 5.2 V (hereinafter, referred to as a "high-voltage signal"), and when the adjustment member 180 is adjusted in the second operation, the hall sensor 171 may output the signal with the voltage of about 0.6 V (hereinafter, referred to as a "low-voltage signal")

Therefore, when the repetitive alternation of the first operation and the second operation of the adjustment member 180 continues, each hall sensor 171 performs an operation of repeatedly alternating the high-voltage signal output and the low-voltage signal output.

### [Effect of cooling unit]

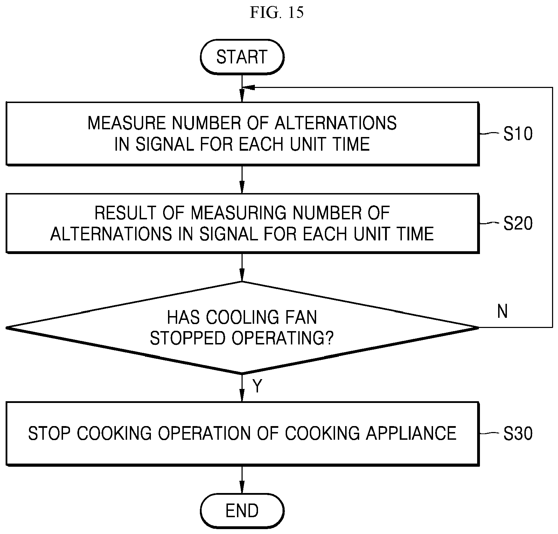

FIG. 14 is a diagram schematically showing a configuration of a cooking appliance according to an embodiment of the present invention, and FIG. 15 is a flowchart schematically showing a control process of a cooking appliance according to an embodiment of the present invention.

The cooking appliance 1 in the present embodiment may include the controller 200 as shown in FIGS. 4 and 9. The controller 200 may control a cooking operation of the cooking appliance 1. For example, the controller 200 may control the operations of the heater and the cooling fan module 110 based on the manipulation signal input via the knob 51 or the like of the control panel 50.

Additionally, the controller 200 may also control the operation of the display 52 of displaying the operating state of the cooking appliance 1. As an example, the controller 200 may be formed by a microcontroller mounted on a circuit board 31.

In addition, the controller 200 may use a result of measuring a magnitude of an electromotive force generated by the operation detecting module 150 to determine whether the operation of the cooling fan module 110 is stopped, and stop the cooking operation of the cooking appliance 1 based on the identified result. A detailed description thereof will be made later.

Referring to FIG. 4 and FIGS. 14 to 15, when the cooking appliance 1 operates in a first set mode, a heater H may be operated, and accordingly, the cooling unit 100 may also be operated together. In this regard, the first set mode may be various cooking operations of the cooking appliance 1 or may be a self-cleaning operation. Hereinafter, a cooling fan failure sensing logic of the cooking appliance 1 will be described using an example when the self-cleaning operation of the cooking appliance 1 is performed.

The self-cleaning function of the cooking appliance 1 is a function of automatically removing contaminants such as oil attached (adhered) to a wall surface of the cooking chamber. The self-cleaning in the cooking appliance 1 is mainly done using a thermal decomposition method called pyrolysis, which burns and removes the contaminants by heating the inside of the cooking chamber with the heat source such as the heater H to maintain a temperature inside the cooking chamber at a high temperature for a long time when the contaminants such as the oil is adhered to the wall surface of the cooking chamber.

While a function in which the heater H operates at the high temperature, such as the self-cleaning function, is performed, the temperature inside the cooking chamber is maintained at the high temperature, and accordingly, this becomes a condition in which a temperature of the electrical component chamber 30 may also rise.

Therefore, when the cooling fan module 110 does not operate properly while the self-cleaning function is performed, the temperature of the electrical component chamber 30 may rise excessively, which increases a possibility that a temperature of the electrical components disposed inside the electrical component chamber 30 increases excessively.

Among the electrical components, the circuit board on which the controller 200 is disposed may be vulnerable to an influence of the heat. A temperature of the circuit board may increase because of heat generation resulted from the operation of the circuit board, and may also increase because of heat from the cavity 11 being transferred to the electrical component chamber 30 and affecting the circuit board.

When such circuit board overheats, the controller 200 may not function properly or, in severe cases, may be damaged, and as a result, the controller 200 may be in a state in which it is difficult to properly control the operation of the entire cooking appliance 1.

Therefore, while the self-cleaning operation as described above is performed, the cooling fan module 110 may also be operated together. When the cooling fan module 110 operates, outside air at the front lower portion of the main body 10 may be introduced via the bottom of the door 16 and then discharged via the top of the door 16 to cool the door 16, and air discharged upwardly of the door 16 may be introduced into the electrical component chamber 30 via the intake port 14 formed through the front panel 13.

Cold air that has flowed into the electrical component chamber 30 may cool the electrical components such as the circuit board, then be sucked into the cooling fan 120, and then be discharged to the outside of the cooking appliance 1 via the exhaust 145.

While the cooling fan module 110 is operating as described above, the operation detecting module 150 may also be operated together.

According to the present embodiment, the operation detecting module 150 may be disposed outside the motor 130, and the motor 130 may be disposed between the cooling fan 120 and the operation detecting module 150. In addition, one side of the shaft 133 rotated by the motor 130 may be connected to the cooling fan 120, and the other side of the shaft 133 may be connected to the operation detecting module 150. In this regard, the other side of the shaft 133 may extend to the outside of the motor casing 135 and be connected to the operation detecting module 150 inside the support casing 190.

Accordingly, when the motor 130 rotates the shaft 133 to operate the cooling fan 120, the shaft 133 may rotate the cooling fan 120 and simultaneously rotate the adjustment member 180 inside the support casing 190. The rotation of the adjustment member 180 may continue without stopping while the cooling fan 120 rotates.

While the adjustment member 180 rotates, the operation of the adjustment member 180 may be repeatedly changed from the first operation to the second operation and again from the second operation to the first operation.

That is to say, when the cooling fan module 110 operates normally, the alternation of the first operation and the second operation of the adjustment member 180 may continue repeatedly in association with the operation of the cooling fan module 110. When the repetitive alternation of the first operation and the second operation of the adjustment member 180 continues as such, each hall sensor 171 performs the operation of repeatedly alternating the high-voltage signal output and the low-voltage signal output.

The signal output from the hall sensor 171 may be transmitted to the controller 200. For example, the board 173 equipped with the hall sensor 171 and the circuit board equipped with the controller 200 may be electrically connected to each other, and thus, the signal output from the hall sensor 171 may be transmitted to the controller 200. The controller 200 may measure the number of changes in the signal transmitted to the controller 200 as such (S10).

The controller 200 may determine whether an abnormality has occurred in the operation of the cooling fan module 110 using the result of measuring the number of changes or each unit time in the signal output from the operation detecting module 150 (S20).

For example, when the number of changes for each unit time in the signal output from the operation detecting module 150 (hereinafter, referred to as the "number of signal alternations for each unit time"), that is, the number of alternations of the first operation and the second operation for each unit time of the adjustment member 180, is smaller than a set value, the controller 200 may determine that the abnormality has occurred in the operation of the cooling fan module 110.

In this regard, the set value may be set as the number of signal alternations for each unit time measured when the cooling fan 120 is rotating at a minimum rotation speed necessary to ensure proper cooling of the electrical component chamber 30.

When it is determined that the operation of the cooling fan 120 has stopped, the controller 200 may stop the cooking operation of the cooking appliance 1 (S30). Accordingly, the operation of the heater H may stop, and the operation of some of the electrical components disposed in the electrical component chamber 30 may also stop.

In the state in which the operation of the cooling fan module 110 is stopped, when the operation of the heater H continues, there is a high possibility that the temperature of the electrical components such as the circuit board will increase excessively. When such state continues, a failure of the electrical components may occur, so that it is not desirable for the heater H to continue when the failure occurs in the cooling fan 120.

Considering the above, in the present embodiment, when it appears that a failure has occurred in the cooling fan module 110, the cooking operation of the cooking appliance 1 may be stopped. Accordingly, even when the cooling of the electrical components is not properly performed because of the failure of the cooling fan module 110, the excessive rising of the temperature of the electrical components or the failure of the electrical components resulted therefrom may be prevented in advance from occurring.

In addition, whether the failure of the cooling fan module 110 has occurred may be determined based on the result of measuring the number of signal alternations occurring in the operation detecting module 150 for each unit time in association with the operation of the cooling fan module 110, so that whether the failure of the cooling fan module 110 has occurred may be quickly identified.

As a result, when the electrical components are not properly cooled because of the failure of the cooling fan module 110, the cooking appliance 1 in the present embodiment quickly identifies the problem and stops the cooking operation, thereby protecting the electrical components from a failure resulted from overheating.

Occasionally, when an abnormality occurs in a mutual relationship between the magnetic member 160 and the adjustment member 180, that is, in a magnetic field, an instantaneous magnetic field change may be applied to the hall sensor 171. When a rotational speed of the cooling fan 120 is measured via the detector 170, a jumping phenomenon in which a speed measurement value momentarily bounces may occur when the instantaneous magnetic field change is applied to the hall sensor 171.

When such a jumping phenomenon appears in a form of an instantaneous lowering of the speed measurement value, an error may occur in the failure sensing result of the cooling fan module 110 based on the result value of measuring the rotational speed of the cooling fan 120.

That is to say, because of the error in the speed measurement value that appears instantaneously by the jumping phenomenon, an incorrect sensing result indicating that the failure of the cooling fan module 110 has occurred may be derived even though the cooling fan module 110 is operating normally.

In contrast, the cooking appliance 1 in the present embodiment only identifies whether the failure of the cooling fan module 110 has occurred based on the result of measuring the number of signal alternations occurring in the operation detecting module 150 for each unit time, and does not measure the rotational speed of the cooling fan 120 to identify whether the failure of the cooling fan module 110 has occurred.

Therefore, even when the jumping phenomenon as described above occurs, it does not significantly affect the result of measuring the number of signal alternations for each unit time. In particular, when the unit time is set sufficiently long, the impact of the jumping phenomenon on the result of measuring the number of signal alternations for each unit time becomes very minimal.

Additionally, in the operation detecting module 150 in the present embodiment, the sensing of the magnetic force by the detector 170 may be performed while the magnetic member 160 and the detector 170 are fixed without rotating.

To measure the number of signal alternations for each unit time, a structure in which the magnetic member rotates instead of the adjustment member 180 may be applied. For example, the magnetic member may be installed on a disk rotating along the shaft 133 and rotate together with the disk. In this case, because a location of the magnetic member changes only when a location thereof relative to the detector 170 changes while the magnetic member rotates, the magnetic member must be disposed eccentrically on the disk.

When the magnetic member is disposed eccentrically and rotates as such, a centrifugal force resulted therefrom may adversely affect the operation of the motor 130 and cause vibration during the operation of the motor 130.

In addition, for the detector 170 to rotate instead of the adjustment member 180 or the magnetic member, an additional structure must be applied to prevent wiring connected to the detector 170 from being affected by the rotation of the detector 170.

In comparison, in the operation detecting module 150 in the present embodiment, the sensing of the magnetic force by the detector 170 may be performed while the adjustment member 180 rotates instead of the magnetic member 160 and the detector 170 rotating.

The adjustment member 180 may be made of a material with lower density than a material of the magnetic member 160, and may not rotate eccentrically. In addition, there is no wiring connected to the adjustment member 180.

The operation detecting module 150 in the present embodiment using such an adjustment member 180 may effectively sense whether the failure has occurred in the cooling fan module 110 without adversely affecting the operation of the motor 130 or having to add the complicated separate structure.

In addition, in the operation detecting module 150 in the present embodiment, a ring magnet with a simple structure, that is, a ring-shaped magnet magnetized in the single-sided two-pole form, may be applied as the magnetic member 160 instead of a multipole magnet with a complex structure.

When the multipole magnet with the complex structure is applied as the magnetic member 160, an overall size, a weight, and a manufacturing cost of the operation detecting module 150 may increase.

In addition, when the multipole magnet is applied as the magnetic member, the hall sensor must be disposed outwardly of the magnetic member in a centrifugal direction. In this case, because it becomes difficult to mount the hall sensor on the circuit board, a structure for fixing the hall sensor must be added, which makes a manufacturing process of the operation detecting module complicated and unnecessarily increases the size of the operation detecting module.

In contrast, in the present embodiment, the ring magnet with the simple structure is applied as the magnetic member 160, so that the overall size, the weight, and the manufacturing cost of the operation detecting module 150 may be reduced, and the manufacturing of the operation detecting module 150 may become easier.

The operation detecting module 150 in the present embodiment as described above has the simple structure and is easily installed, so that whether the failure has occurred in the cooling fan module 110 may be effectively identified.

The cooking appliance 1 in the present embodiment equipped with such an operation detecting module 150 may effectively protect the electrical components from the failure resulted from the overheating while suppressing increases in the manufacturing cost and a manufacturing time.

Additionally, the operation detecting module 150 in the present embodiment does not need to sense a voltage of the motor 130 disposed in the cooling fan module 110 to acquire information necessary to determine whether the cooling fan module 110 has stopped operating. The operation detecting module 150 simply uses the rotation of the shaft 133 to acquire the information necessary to determine whether the cooling fan module 110 has stopped operating.

Accordingly, the operation detecting module 150 in the present embodiment may acquire the information necessary to determine whether the cooling fan module 110 has stopped operating, regardless of whether the motor 130 that operates the cooling fan 120 is an AC motor or a DC motor.

That is to say, the cooking appliance 1 in the present embodiment may effectively identify whether the failure has occurred in the cooling fan module 110 regardless of the type of motor.

In one example, in the present embodiment, the pair of hall sensors 171 may be disposed in the detector 170, and the pair of vanes 183 and the pair of through portions 184 may be formed in the adjustment member 180. Accordingly, when the vane 183 is at the first location while the adjustment member 180 rotates, the magnetic force of the magnetic member 160 may be sensed by all of the hall sensors 171. When the vane 183 is at the second location, neither hall sensor 171 may sense the magnetic force of the magnetic member 160.

When the hall sensors 171 and the vanes 183 are arranged as such, even when a failure occurs in one of the hall sensors 171, the failure sensing work for the cooling fan module 110 may continue via the other hall sensor 171.

That is to say, the operation detecting module 150 in the present embodiment formed in the shape described above may effectively improve stability of the failure sensing operation for the cooling fan module 110.

The present invention has been described with reference to the embodiment shown in the drawings, but this is merely illustrative. Those skilled in the art will understand that various modifications and other embodiments are possible. Therefore, the true technical protection scope of the present invention should be determined by the scope of the patent claims below.

## Claims

1. A cooling unit (100) comprising:
a cooling fan (120) configured to rotate and generate a flow of cold air; and
an operation detecting module (150) configured to sense the rotation of the cooling fan (120),
wherein the operation detecting module (150) includes a magnetic member (160) configured to generate a magnetic force, a detector (170) configured to sense the magnetic force, and an adjustment member (180) configured to open and close a passage where the magnetic force passes between the magnetic member (160) and the detector (170),
wherein when the cooling fan (120) rotates, the adjustment member (180) operates such that a first operation of opening the passage and a second operation of closing the passage are alternately performed in a repeated manner.

2. The cooling unit of claim 1, wherein the adjustment member (180) is configured to rotate in association with the rotation of the cooling fan (120),
wherein the operation of the adjustment member (180) changes from the first operation to the second operation or from the second operation to the first operation by the rotation of the adjustment member (180).

3. The cooling unit of claim 1 or 2, wherein the adjustment member (180) includes a vane (183) configured to rotate in association with the rotation of the cooling fan (120) and circulate between a first location of blocking the passage and a second location of not blocking the passage,
wherein when the vane (183) is at the first location, the adjustment member (180) operates in the first operation, and when the vane (183) is at the second location, the adjustment member (180) operates in the second operation.

4. The cooling unit of claim 3, wherein the adjustment member (180) includes:
a coupling shaft (181) coupled to a shaft (133) of a motor (130) configured to rotate the cooling fan (120) and rotating together with the shaft (133); and
the vane (183) disposed between the magnetic member (160) and the detector (170), protruding in a centrifugal direction from the coupling shaft (181), and configured to rotate together with the coupling shaft (181).

5. The cooling unit of claim 3 or 4, wherein the adjustment member (180) includes the vane (183) configured to block the magnetic force in the passage, and a through portion (184) configured to allow the magnetic force to pass through the passage,
wherein the vane (183) and the through portion (184) are arranged in a rotation direction of the adjustment member (180).

6. The cooling unit of any one of claims 1 to 3, further comprising a motor (130) configured to rotate the cooling fan (120), and a support casing (190) coupled with the motor (130),
wherein the operation detecting module (150) is disposed in a space surrounded by the motor (130) and the support casing (190).

7. The cooling unit of any one of claims 1 to 3, further comprising a motor (130) disposed between the cooling fan (120) and the operation detecting module (150) and configured to rotate the cooling fan (120) and the adjustment member (180),
wherein the cooling fan (120) is connected to a shaft (133) of the motor (130) on one side of the motor (130),
wherein the adjustment member (180) is connected to the shaft (133) on the other side of the motor (130).

8. The cooling unit of claim 7, further comprising a support casing (190) coupled to the motor (130) on the other side of the motor (130),
wherein the operation detecting module (150) is disposed in a space surrounded by the motor (130) and the support casing (190).

9. The cooling unit of claim 8, wherein the magnetic member (160) is coupled to the motor (130),
wherein the detector (170) is coupled to the support casing (190),
wherein the adjustment member (180) is disposed between the magnetic member (160) and the detector (170) and coupled to the shaft (133).

10. The cooling unit of any one of claims 4 to 8, wherein the magnetic member (160), the adjustment member (180), and the detector (170) are arranged in a row along a longitudinal direction of the shaft (133),
wherein the adjustment member (180) is disposed between the magnetic member (160) and the detector (170).

11. The cooling unit of claim 10, wherein the support casing (190) includes an accommodating portion (191) configured to accommodate the operation detecting module (150) therein, and a coupling portion (193) configured to couple the accommodating portion (191) to the motor (130),
wherein the detector (170) is installed on a board (173) coupled to the support casing (190) inside the accommodating portion (191),
wherein the magnetic member (160) is coupled to the motor (130),
wherein the adjustment member (180) is disposed between the magnetic member (160) and the detector (170) inside the accommodating portion (191).

12. A cooking appliance comprising the cooling unit (100) of any one of the preceding claims.

13. The cooking appliance of claim 12, further comprising a cavity (11) having a cooking chamber (15) defined therein, and a heater configured to heat the cooking chamber (15).

14. The cooking appliance of claim 13, further comprising a controller (200) configured to control an operation of the heater using a result of monitoring the number of alternations of the first operation and the second operation for each unit time.

15. The cooking appliance of claim 14, wherein the controller (200) is configured to stop the operation of the heater when the number of alternations of the first operation and the second operation for each unit time is smaller than a set value.
